# EUROPÄISCHE PATENTSCHRIFT

(11) **EP 0 919 917 B1**
(45) Veröffentlichungstag und Bekanntmachung des Hinweises auf die Patenterteilung: **22.01.2003**
(21) Anmeldenummer: 98440220.6
(22) Anmeldetag: 09.10.1998
(51) Int. Cl.: G06F 11/267, G11C 29/00, G06F 12/00

(54) **Verfahren zum Testen des Pufferspeichers eines Mikroprozessorsystems**
Method to test the buffer memory of a microprocessor system
Procédé de test de la mémoire tampon d'un system micro-processeur

(30) Priorität: 07.11.1997 DE 19749240
(43) Veröffentlichungstag der Anmeldung: 02.06.1999
(73) Patentinhaber: ALCATEL, 75008 Paris (FR)
(72) Erfinder: Mandl, Thomas, 1210 Wien (AT)
(74) Vertreter: Rausch, Gabriele, Dr.

(56) Entgegenhaltungen:
- US-A- 5 680 544

## Beschreibung

Die Erfindung betrifft ein Verfahren zum Testen des Pufferspeichers eines Mikroprozessorsystems.

Leistungsfähige Mikroprozessorsysteme benötigen neben Mikroprozessoren mit hohen Verarbeitungsgeschwindigkeiten auch Datenspeicher mit hoher Speicherkapazität und kurzen Zugriffszeiten. Eine grundlegende Eigenschaft von Datenspeichern ist jedoch, daß mit zunehmender Speicherkapazität auch die Zugriffszeiten wachsen. Aus diesem Grunde werden in Mikroprozessorsystemen Datenspeicher unterschiedlicher Hierarchie eingesetzt. So gibt es neben großen Hauptspeichern mit relativ langen Zugriffszeiten zusätzliche Registerspeicher innerhalb eines Mikroprozessors, die oft aus nur wenigen Speicherplätzen ("Registern") bestehen und extrem kurze Zugriffszeiten erlauben. Mikroprozessoren und viele andere Systembausteine bestehen zu einem Großteil aus derartigen Registerspeichern.

Pufferspeicher, die häufig auch als Cache bezeichnet werden, stehen in dieser Hierarchie zwischen Hauptspeichern und Registerspeichern. Sie haben die Aufgabe, die während einer Programmausführung jeweils aktuellen Hauptspeicherinhalte dem Mikroprozessor möglichst schnell als "Kopien" zur Verfügung zu stellen. Die Pufferspeicher befinden sich entweder direkt auf dem Mikroprozessorchip (sog. "first-level" oder "on-chip cache") oder sind unabhängige Bausteine ("second level cache").

In Pufferspeichern treten genauso wie in anderen Datenspeichern mit einer gewissen Wahrscheinlichkeit Fehler auf. So kann etwa eine Speicherzelle dauerhaft einen festen Wert (Null oder Eins) annehmen, ohne daß sich dieser wieder durch Überschreiben ändern läßt. Ein solches, auch als "stuck-at"-Fehler bezeichnetes Fehlerverhalten kann beispielsweise durch einen Kurzschluß innerhalb der Speicherzelle hervorgerufen werden. Ein Mikroprozessor, der Leseoperationen auf einen solchen fehlerhaften Pufferspeicher durchführt, erhält fehlerhafte Daten und ermittelt in aller Regel daraus unrichtige Ergebnisse.

Daher sind Verfahren entwickelt worden, mit deren Hilfe sich die Funktion von Pufferspeichern testen läßt. Die meisten bekannten Mikroprozessoren führen beim Booten nach einem Systemreset einen Selbsttest durch, bei dem auch die Funktion des "first level" Pufferspeichers überprüft wird. Da die Ausführung dieser Selbsttests fest auf dem Mikroprozessor verdrahtet ist, ist nicht bekannt, wie diese Selbsttests im Einzelnen durchgeführt werden. Nachteilig bei diesen Selbsttests ist jedoch, daß sie nur nach einem Systemreset durchführbar sind. Ein Fehler während des laufenden Betriebs des Mikroprozessorsystems wird nicht erkannt.

US 5,680,544 beschreibt ein Verfahren zum Testen eines Cache Speichers, bei welchem der Cache-Speicher mit Hilfe von Registerspeichern mit Testmustern (vectors) beschrieben wird. Die eingeschriebenen Daten werden dann zurückgelesen und mit den erwarteten Werten verglichen. Dieser Test findet "offline" statt, d.h. im Zuge einer expliziten Überprüfung des Cache-Speichers.

Vor allem in Bereichen, in denen Mikroprozessorsysteme sicherheitskritische Aufgaben übernehmen, etwa in der Luft- und Raumfahrt oder in der Eisenbahnsignaltechnik, können während des Betriebs auftretende Fehler in Pufferspeichern zu katastrophalen Folgen führen, wenn sie nicht möglichst bald nach ihrem Auftreten erkannt werden.

Es ist daher Aufgabe der Erfindung, ein Verfahren zum Testen des Pufferspeichers eines Mikroprozessorsystems anzugeben, welches auch während des Betriebs des Mikroprozessorsystems durchführbar ist.

Die Erfindung löst diese Aufgabe mit Hilfe der in Anspruch 1 angegebenen Merkmale. Erfindungsgemäß wird der Inhalt des Pufferspeichers mit dem Inhalt eines Referenzspeichers verglichen. Der Vergleich läßt sich durchführen, ohne daß dazu Daten oder Befehle des im Vordergrund ablaufenden Programms modifiziert oder gar überschrieben werden. Somit ist das Verfahren geeignet, während des laufenden Betriebs des Mikroprozessorsystems im Hintergrund abzulaufen. Da gerade Mikroprozessorsysteme in sicherheitskritischen Anwendungen häufig sehr lange ohne Unterbrechung in Betrieb sind, lassen sich während des Betriebs auftretende Fehler sehr zuverlässig entdecken und geeignete Maßnahmen (Warnhinweise etc.) einleiten. Dies führt zu einem wesentlichen Zuwachs an Sicherheit.

Nach einem vorteilhaften Ausführungsbeispiel ist der Referenzspeicher ein Registerspeicher. Zusätzliche Speicherbausteine für den Referenzspeicher sind bei diesem Ausführungsbeispiel nicht erforderlich.

Bei einem Ausführungsbeispiel nach wird der Test auf der Grundlage eines speziell für Testzwecke gewählten Test-Bitmusters durchgeführt. Die Verwendung spezieller Test-Bitmuster wirkt sich vorteilhaft auf die Zuverlässigkeit des Tests aus.

Weitere vorteilhafte Ausgestaltungen der Erfindung sind den Unteransprüchen entnehmbar. Die Erfindung wird nachfolgend anhand der Ausführungsbeispiele und der Zeichnungen eingehend erläutert. Es zeigen:
- Fig. 1:: Eine Prinzipskizze zur Erläuterung der Architektur eines Mikroprozessor-systems MPS;
- Fig. 2:: Eine schematische Darstellung ausgewählter Komponenten eines Mikroprozessorsystems zur Erläuterung der Erfindung;
- Fig. 3:: Ein Blockdiagramm zur Erläuterung eines vorteilhaften Ausführungsbeispiels der Erfindung;
- Fig. 4:: Eine Übersicht über die Architektur des "first-level" Pufferspeichers des INTEL® i486 Mikroprozessors.

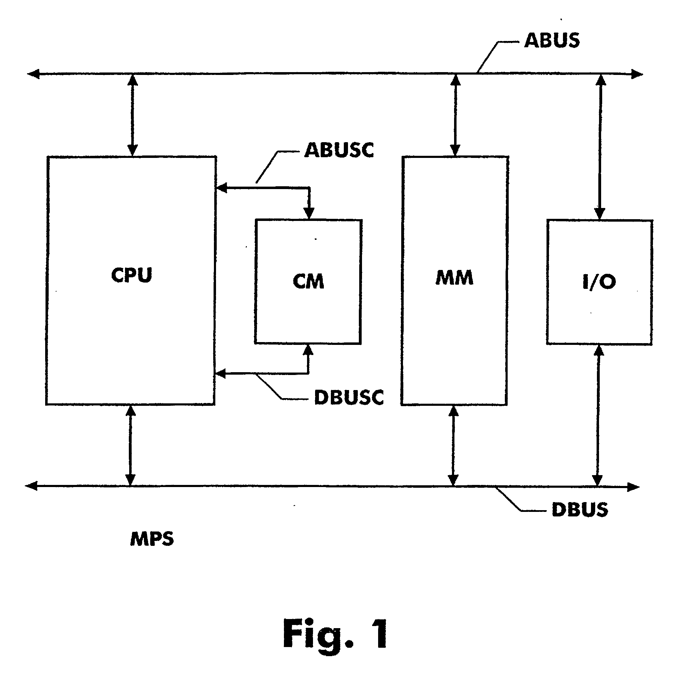

Fig. 1 zeigt in stark vereinfachter Darstellung ein Mikroprozessorsystem MPS. Das Mikroprozessorsystem MPS umfaßt einen Mikroprozessor CPU, einen Pufferspeicher CM, einen Hauptspeicher MM sowie eine Ein-/Ausgabeeinheit 1/O. Die Adressierung zwischen dem Mikroprozessor, dem Hauptspeicher und der Ein-/Ausgabeeinheit erfolgt über einen Adreßbus ABUS. Für den Datenaustausch zwischen diesen Komponenten steht ein vom Adreßbus ABUS unabhängiger Datenbus DBUS zur Verfügung. Der Pufferspeicher CM ist meist über einen eigenen Adreß- und Datenbus ABUSC bzw. DBUSC mit dem Mikroprozessor verbunden. Beim Pufferspeicher CM kann es sich um einen gemeinsam mit dem Mikroprozessor auf einem Chip angeordneten "first-level" Pufferspeicher oder auch um einen unabhängig davon aufgebauten "second-level" Pufferspeicher handeln. Es gibt auch Mikroprozessorsysteme, die sowohl einen "first-level" als auch einen "second-level" Pufferspeicher haben. Auf derartige Mikroprozessorsysteme wird weiter unten kurz eingegangen. Üblicherweise haben Mikroprozessorsysteme eine Speicherverwaltungseinheit ("memory management unit"), deren Anordnung im Adreßbus jedoch von der Art der Adressierung (virtuell oder real) abhängt. Sie ist deswegen in Fig. 1 nicht dargestellt.

Erfindungsgemäß wird nun dafür gesorgt, daß in den Pufferspeicher CM und einen Referenzspeicher, der z. B. ein zum Mikroprozessor gehörender Registerspeicher sein kann, die gleichen Daten geschrieben werden. Anschließend werden die Daten aus den beiden Speichern wieder ausgelesen und vom Mikroprozessor CPU daraufhin überprüft, ob sie übereinstimmen. Falls der Mikroprozessor dabei keine Übereinstimmung feststellt, so liegt ein Fehler im Pufferspeicher vor, sofern man von einer einwandfreien Funktion des Referenzspeichers ausgehen kann (z. B. aufgrund von zusätzlichen Tests für den Referenzspeicher). Aus den nachfolgend beschriebenen Ausführungsbeispielen wird deutlich, welche Möglichkeiten bei der Durchführung des Tests im einzelnen bestehen.

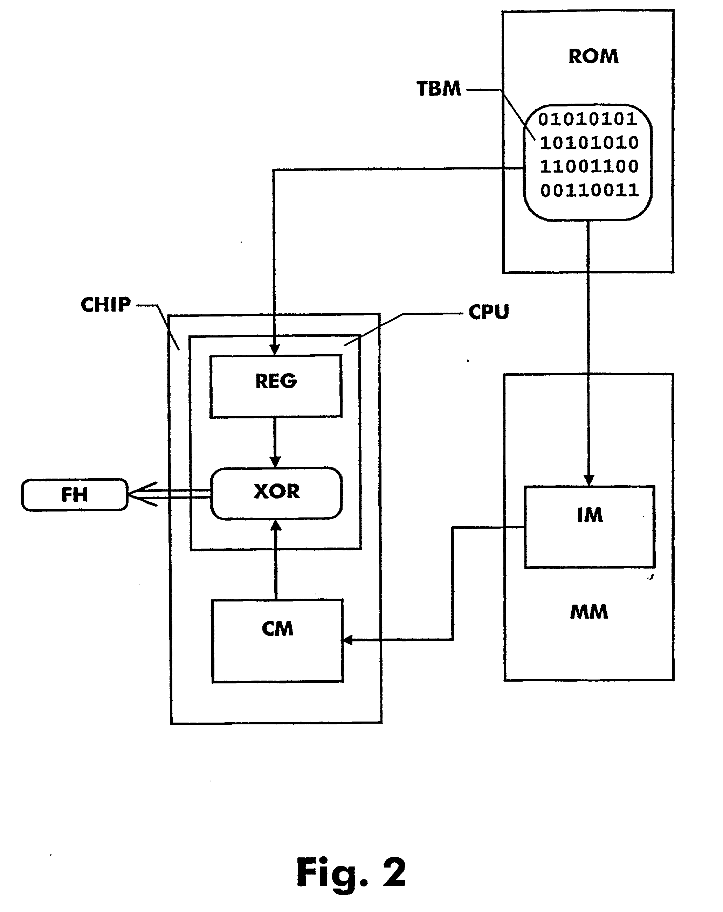

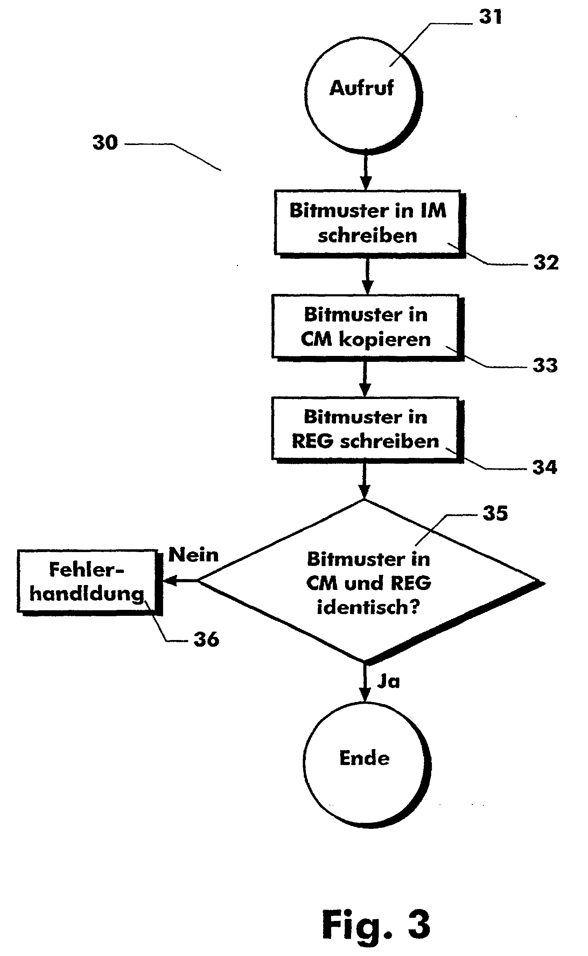

Zur Erläuterung eines ersten vorteilhaften Ausführungsbeispiels der Erfindung wird im folgenden auf die Fig. 2 und Fig. 3 Bezug genommen. Fig. 2 zeigt einen Hauptspeicher MM sowie einen Chip CHIP, auf dem ein "first-level" Pufferspeicher CM sowie ein Mikroprozessor CPU angeordnet sind. Der Mikroprozessor umfaßt einen Registerspeicher REG und die eigentlichen Verarbeitungseinheiten. Der Adreß- und Datenaustausch zwischen den einzelnen Komponenten erfolgt wie oben erläutert über einen Adreßbus bzw. einen Datenbus, die jedoch der Übersicht halber ebenso wie die Verarbeitungseinheiten nicht dargestellt sind. Die Pfeile in Fig. 2 geben lediglich den Informationsfluß zwischen den Komponenten an.

Fig. 3 zeigt ein Flußdiagramm, in dem die wichtigsten Schritte bei der Durchführung des Pufferspeichertests 30 dargestellt sind. Nach dem Aufruf 31 des Pufferspeicher-Tests wird zunächst in einem Schritt 32 ein Test-Bitmuster TBM von einem nicht überschreibbaren Speicher ROM in einen pufferbaren Zwischenspeicher IM geschrieben. Der pufferbare Zwischenspeicher IM kann ein eigens für Testzwecke vorgesehener Speicherbaustein sein. Vorzugsweise wird jedoch, wie in Fig. 2 erkennbar, ein als pufferbar deklarierter Bereich des Hauptspeichers MM als Zwischenspeicher IM definiert. Die Speicherkapazität des Zwischenspeichers IM entspricht genau der Größe des zu testenden Pufferspeichers CM.

Anschließend wird das Test-Bitmuster TBM in einem Schritt 33 vom Zwischenspeicher IM in den Pufferspeicher CM kopiert. Dies geschieht vorzugsweise so, daß der Mikroprozessor CPU auf das Test-Bitmuster TBM einen Lesezugriff durchführt, wodurch dieses vom Zwischenspeicher IM in den Pufferspeicher CM kopiert wird. Die Einzelheiten bei diesem Kopiervorgang hängen vom verwendeten Mikroprozessortyp ab. In einem weiter unten erläuterten Ausführungsbeispiel, welches sich auf einen konkreten Mikroprozessor bezieht, wird auf diesen Punkt noch einmal eingegangen.

In einem weiteren Schritt 34 wird das Test-Bitmuster TBM von dem nicht überschreibbaren Speicher ROM aus in den Referenzspeicher REG geschrieben. Vorzugsweise handelt es sich bei dem Referenzspeicher REG um einen zum Mikroprozessor CPU gehörenden Registerspeicher. Es ist jedoch ebenso möglich, für diesen Zweck einen eigens dafür vorgesehenen Speicherbaustein zu verwenden. Anschließend vergleicht der Mikroprozessor CPU in einem Schritt 35 das Test-Bitmuster aus dem Pufferspeicher CM mit dem im Referenzspeicher REG abgelegten Test-Bitmuster TBM. In Fig. 2 ist dieser Vergleich durch das Bezugszeichen XOR gekennzeichnet. Bei einwandfreier Funktion des Pufferspeichers CM müssen die beiden Test-Bitmuster übereinstimmen. Stimmen die beiden Test-Bitmuster nicht überein, so veranlaßt der Mikroprozessor CPU in einem Schritt 36 die Durchführung einer Fehlerhandlung FH. Welche Fehlerhandlung im einzelnen vorzunehmen ist, bestimmt sich nach dem Einsatzzweck des Mikroprozessorsystems. Bei redundant ausgelegten Mikroprozessorsystemen, wie sie etwa in Flugzeugen oder Stellwerken eingesetzt werden, könnte die Fehlerhandlung darin bestehen, ein als fehlerhaft erkanntes Mikroprozessorsystem von den anderen fehlerfreien Mikroprozessorsystemen zu isolieren.

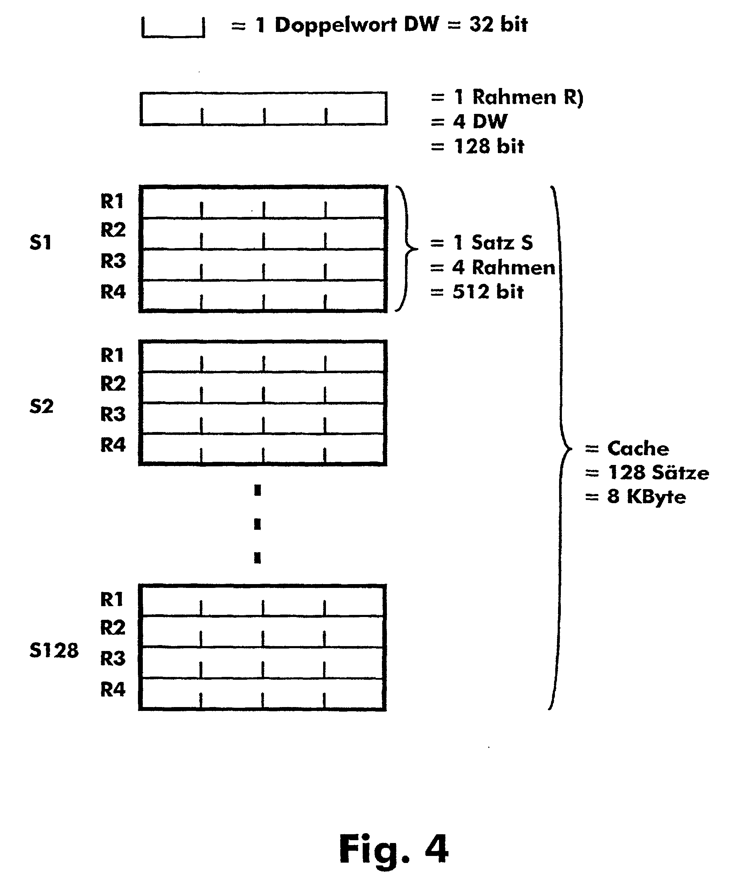

In einem konkreten Ausführungsbeispiel der Erfindung handelt es sich bei dem zu testenden Pufferspeicher um den "first-level cache" des Mikroprozessors INTEL® i486. Dieser Pufferspeicher ist als sog. "Four-way-set-associative-Cache" konzipiert. In Fig. 4 ist die Pufferspeicherarchitektur dieses Mikroprozessors skizziert. Der Pufferspeicher besteht aus 128 Sätzen S1...S128 zu jeweils vier Rahmen R1...R4. Jeder Rahmen ist seinerseits aus jeweils vier Doppelwörtern DW zusammengesetzt. Da ein Doppelwort aus 32 Bit besteht, beträgt die Speicherkapazität des Pufferspeichers 32*4*128 Bit = 8 KByte. Wie im einzelnen die Adressierung erfolgt, ist in diesem Zusammenhang nicht entscheidend.

Erfindungsgemäß wird nun zunächst dafür gesorgt, daß das Programmodul, welches den Ablauf des erfindungsgemäßen Testverfahrens steuert, in einen als nicht pufferbar deklarierten Speicherbereich geladen wird. Dadurch ist gewährleistet, daß Programmbefehle während der Durchführung des Tests nicht gepuffert werden und somit den Test nicht stören können. Bei diesem nicht als pufferbar deklarierten Speicherbereich kann es sich beispielsweise um einen Bereich eines nicht überschreibbaren Speichers ROM (siehe Fig. 2) handeln. Anschließend wird im Hauptspeicher des Mikroprozessorsystems ein "page-aligned" Speicherblock von der Größe des Pufferspeichers (= 8 KByte) als Zwischenspeicher IM definiert. Jede Speicherzelle dieses Zwischenspeichers IM wird mit einem 32 Bit langen Test-Bitmuster aufgefüllt, welches vorzugsweise ebenfalls im nicht überschreibbaren Speicher ROM abgelegt ist. Geeignete Test-Bitmusters sind z. B. der CENELEC-Norm *"Railway Applications: Safety-Related Electronic Railway Control and Protection Systems", CENELEC pr EN 50129 Draft 7 (1993),* entnehmbar. Damit es während der Ausführung des Tests nicht zu einer Unterbrechung kommt, werden alle Interrupts außer Kraft gesetzt; ferner wird der Inhalt des Pufferspeichers fortan als leer betrachtet ("flushed").

In einem nächsten Schritt führt der Mikroprozessor INTEL® i486 einen Lesezugriff auf das im Zwischenspeicher IM (= Teil des Hauptspeichers MM) abgelegte Test-Bitmuster TBM durch, wodurch das Test-Bitmuster in den Pufferspeicher CM kopiert wird. Das dem so ist, hängt mit der beim INTEL® i486 und auch bei vielen anderen Mikroprozessoren üblichen Speicherverwaltung des Pufferspeichers zusammen. Die Speicherverwaltung ist so ausgelegt, daß bei Lesezugriffen des Mikroprozessors zunächst überprüft wird, ob ein zur angegebenen Hauptspeicheradresse gehörender Eintrag im Pufferspeicher ist. Falls dies zutrifft, so liest der Mikroprozessor den Eintrag aus dem Pufferspeicher. Falls hingegen kein entsprechender Eintrag im Pufferspeicher ist, so wird das Datum vom Hauptspeicher in den Pufferspeicher kopiert und zusätzlich dem Mikroprozessor zugeleitet. Erst bei einem zweiten Lesezugriff liest der Mikroprozessor das Datum direkt aus dem Pufferspeicher, sofern das Datum nicht inzwischen bereits überschrieben worden ist.

Allerdings kann das Test-Bitmuster TBM nicht durch einen einzigen Lesezugriff in den Pufferspeicher CM kopiert werden. Vielmehr wird der Pufferspeicher CM Rahmen für Rahmen mit dem Test-Bitmuster aus dem Bereich IM des Hauptspeichers MM aufgefüllt. Dies hängt damit zusammen, daß die Adressierung des Pufferspeichers beim INTEL® i486 wie auch bei den meisten anderen Mikroprozessoren rahmenorientiert ist. Die Rahmenorientierung hat zur Folge, daß nicht nur ein angefordertes Doppelwort, sondern ein ganzer Rahmen von vier Doppelwörtern im voraus geladen wird ("data prefetch"). Da der Pufferspeicher des INTEL® i486 wie in Fig. 4 dargestellt insgesamt 128 Rahmen umfaßt, sind folglich 128 Lesezugriffe erforderlich, um den Pufferspeicher vollständig mit dem Test-Bitmuster zu füllen.

Nach dem Auffüllen des Pufferspeicher CM mit dem Test-Bitmuster TBM wird das im nicht überschreibbaren Speicher ROM abgelegte Test-Bitmuster TBM in einen als Referenzspeicher dienenden Registerspeicher REG des Mikroprozessors CPU kopiert. Grundsätzlich ist es ebenso möglich, diesen Kopiervorgang auch vor dem Auffüllen des Pufferspeichers vorzunehmen. Der Mikroprozessor CPU liest nun nacheinander Doppelwörter (= 32 Bit) aus dem Pufferspeicher aus, indem er, wie oben erläutert, auf eine entsprechende Adresse im Zwischenspeicher IM zugreift. Jedes aus dem Pufferspeicher ausgelesene Doppelwort wird mit dem in den Registerspeicher REG kopierten Test-Bitmuster TBM verglichen, z. B. Hilfe der Bool'schen Operation EXOR. Stimmen die beiden miteinander verglichenen Test-Bitmuster nicht überein, so veranlaßt der Mikroprozessor eine Fehlerhandlung.

Bei diesem Ausführungsbeispiel wird der Pufferspeicher CM vollständig aufgefüllt und anschließend Rahmen für Rahmen mit dem Inhalt des Referenzspeichers verglichen. Ebenso ist es natürlich möglich, zunächst nur einen Rahmen des Pufferspeichers CM mit dem Test-Bitmuster TBM zu füllen, diesen mit dem Inhalt des Referenzspeichers REG zu vergleichen, anschließend den nächsten Rahmen des Pufferspeichers zu füllen und mit dem Inhalt des Referenzspeichers zu vergleichen usw. Bei diesem alternativen Vorgehen wird der Pufferspeicher also nicht zunächst vollständig aufgefüllt, bevor es zu einem Vergleich mit dem Inhalt des Referenzspeichers kommt. Vielmehr wird das Auffüllen und das Vergleichen im stetiges Wechsel durchgeführt.

Falls das Mikroprozessorsystem anstelle eine "first-level" einen "second-level" Pufferspeicher hat, so läßt sich dieser in der gleichen Weise testen wie vorstehend beschrieben. Bei Mikroprozessorsystemen, die neben dem "first-level" zusätzlich noch einen "second-level" Pufferspeicher haben, ist lediglich dafür Sorge zu tragen, daß jeder beiden Pufferspeicher einzeln getestet wird. Vorzugsweise wird dies dadurch erreicht, daß vor dem Test des einen Pufferspeichers der jeweils andere inaktiviert wird.

## Patentansprüche

1. Verfahren zum Testen des Pufferspeichers (CM in Fig. 2) eines Mikroprozessorsystems, wobei der Inhalt des Pufferspeichers (CM) mit dem Inhalt eines Referenzspeichers (REG) verglichen wird,
**dadurch gekennzeichnet, dass** das Verfahren im Hintergrund während des laufenden Betriebs des Mikroprozessor systems durchgeführt wird und die folgenden Schritte aufweist:
a) ein Test-Bitmuster (TBM) wird in einen Zwischenspeicher (IM) geschrieben (32),
b) das Test-Bitmuster (TBM) wird vom Zwischenspeicher (IM) in den zu testenden Pufferspeicher (CM) kopiert (33),
c) das Test-Bitmuster (TBM) wird in den Referenzspeicher (REG) kopiert (34),
d) der Mikroprozessor (CPU) prüft, ob das in den Pufferspeicher (CM) kopierte Test-Bitmuster mit dem in den Referenzpeicher (REG) kopierten Test-Bitmuster übereinstimmt (35),
e) der Mikroprozessor (CPU) veranlaßt die Durchführung einer Fehlerhandlung (36), sofern bei der Prüfung nach d) keine Übereinstimmung festgestellt wird.

2. Verfahren nach Anspruch 1, bei dem vor Durchführung der genannten Schritte alle Interrupts des Mikroprozessors außer Kraft gesetzt werden.

3. Verfahren nach Anspruch 1, bei dem die Fehlerhandlung darin besteht, dass ein als fehlerhaft erkanntes Mikroprozessorsystem von den anderen fehlerfreien Mikroprozessorsystemen isoliert wird.

4. Verfahren nach Anspruch 1, bei dem der Referenzspeicher (REG) ein Registerspeicher ist.

5. Verfahren nach Anspruch 1, bei dem der Zwischenspeicher (IM) ein pufferbarer Bereich eines Hauptspeichers (MM) des Mikroprozessorsystems ist.

6. Verfahren nach Anspruch 1, bei dem die Überprüfung nach Schritt d) mit Hilfe einer Bool'schen XOR-Operation durchgeführt wird.

7. Verfahren nach einem der vorhergehenden Ansprüche, bei dem der zu testende Pufferspeicher (CM) sich auf demselben Chip (CHIP) wie der Mikroprozessor (CPU) befindet.

8. Verfahren nach Anspruch 1, bei dem das Programmodul zur Steuerung des Tests in einem nicht überschreibbaren und nicht pufferbaren Speicher (ROM) gespeichert ist.

9. Programmodul mit einer Anzahl von Steuerbefehlen,
**dadurch gekennzeichnet, daß** die Steuerbefehle so angeordnet sind, daß sie ein Verfahren nach einem der vorhergehenden Ansprüche steuern.

10. Datenträger, auf dem ein Programmodul nach Anspruch 9 gespeichert ist.

## Claims

1. A method for testing the buffer memory (CM in Fig. 2) of a microprocessor system, wherein the contents of the buffer memory (CM) are compared with the contents of a reference memory (REG),
**characterised in that** the method is implemented in the background during ongoing operation of the microprocessor system and comprises the following steps:
a) a test bit pattern (TBM) is written (32) to an intermediate memory (IM),
b) the test bit pattern (TBM) is copied (33) from the intermediate memory (IM) to the buffer memory (CM) to be tested,
c) the test bit pattern (TBM) is copied (34) to the reference memory (REG),
d) the microprocessor (CPU) examines whether the test bit pattern copied to the buffer memory (CM) concords (35) with the test bit pattern copied to the reference memory (REG),
e) if no concordance is established in the course of the check according to d), the microprocessor (CPU) instigates the implementation of a fault-handling procedure (36).

2. Method according to Claim 1, wherein all interrupts of the microprocessor are rendered ineffective prior to implementation of the specified steps.

3. Method according to Claim 1, wherein the fault-handling procedure consists in a microprocessor system that has been recognised to be faulty being isolated from the other, fault-free microprocessor systems.

4. Method according to Claim 1, wherein the reference memory (REG) is a register memory.

5. Method according to Claim 1, wherein the intermediate memory (IM) is a bufferable area of a main memory (MM) of the microprocessor system.

6. Method according to Claim 1, wherein the examination according to step d) is carried out with the aid of a Boolean XOR operation.

7. Method according to one of the preceding claims, wherein the buffer memory (CM) to be tested is located on the same chip (CHIP) as the microprocessor (CPU).

8. Method according to Claim 1, wherein the program module for controlling the test is stored in a non-overwritable and non-bufferable memory (ROM).

9. A program module with a number of control commands,
**characterised in that** the control commands are organised in such a way that they control a method according to one of the preceding claims.

10. A data carrier on which a program module according to Claim 9 is stored.

## Revendications

1. Procédé pour tester la mémoire-tampon (CM sur la figure 2) d'un système à microprocesseurs, le contenu de la mémoire-tampon (CM) étant comparé au contenu d'une mémoire de référence (REG), **caractérisé en ce que** le procédé est effectué en toile de fond pendant le fonctionnement en cours du système à microprocesseur, et présente les étapes suivantes :
a) un profil binaire de test (TBM) est inscrit sur une mémoire temporaire (IM) (32),
b) le profil binaire de test (TBM) est copié de la mémoire temporaire (IM) vers la mémoire-tampon à tester (33),
c) le profil binaire de test (TBM) est copié vers la mémoire de référence (REG) (34),
d) le microprocesseur (CPU) vérifie si le profil binaire de test (TBM) copié vers la mémoire-tampon (CM) concorde avec le profil binaire de test copié vers la mémoire de référence (REG) (35),
e) le microprocesseur (CPU) lance l'exécution d'un traitement d'erreurs (36) dans la mesure où lors de la vérification selon d), une concordance n'a pas été établie.

2. Procédé selon la revendication 1, lors duquel avant l'exécution des étapes mentionnées, toutes les interruptions du microprocesseur sont désactivées.

3. Procédé selon la revendication 1, lors duquel le traitement d'erreurs consiste à isoler un système à microprocesseurs reconnu comme défectueux des autres systèmes à microprocesseurs parfaits.

4. Procédé selon la revendication 1, lors duquel la mémoire de référence (REG) est une mémoire de registres.

5. Procédé selon la revendication 1, lors duquel la mémoire temporaire (IM) est une zone d'une mémoire principale (MM) d'un système à microprocesseurs qui peut se mettre en mémoire-tampon.

6. Procédé selon la revendication 1, lors duquel la vérification selon l'étape d) est effectuée à l'aide d'une opération boléenne XOR.

7. Procédé selon l'une quelconque des revendications précédentes, lors duquel la mémoire-tampon (CM) à tester se trouve sur la même puce (CHIP) que le microprocesseur (CPU).

8. Procédé selon la revendication 1, lors duquel le module de programmes pour la commande des tests est mémorisé sur une mémoire morte (ROM) qui ne peut pas être mise en mémoire-tampon.

9. Module de programmes avec un nombre d'instructions de commande, **caractérisé en ce que** les instructions de commandes sont disposées de telle façon qu'elles commandent un procédé selon l'une quelconque des revendications précédentes.

10. Support de données sur lequel un module de programmes selon la revendication 9 est mémorisé.
